## Europäisches Patentamt

## European Patent Office

## Office européen des brevets

(11) Veröffentlichungsnummer: **0 134 960**

**B1**

(12) # EUROPÄISCHE PATENTSCHRIFT

(45) Veröffentlichungstag der Patentschrift:
22.07.87

(51) Int. Cl.⁴: **H 01 S 3/13,** H 01 S 3/10

(21) Anmeldenummer: **84107736.5**

(22) Anmeldetag: **04.07.84**

(54) Schaltungsanordnung zur Ansteuerung von Halbleiterlasern.

(30) Priorität: **14.07.83 DE 3325420**

(43) Veröffentlichungstag der Anmeldung:
**27.03.85 Patentblatt 85/13**

(45) Bekanntmachung des Hinweises auf die Patenterteilung:
**22.07.87 Patentblatt 87/30**

(84) Benannte Vertragsstaaten:
**FR GB IT NL**

(56) Entgegenhaltungen:
GB-A-2 066 557

PATENTS ABSTRACTS OF JAPAN, Band 7, Nr. 204
(E-197)(1349), September 9, 1983;
TECHNISCHES MESSEN, T.M., Band 50, Nr. 2,
Februar 1983, Seiten 49-54, München, DE; W.S.
LUDOLF: "Grundlagen der optischen
Übertragungstechnik - Eine Einführung für
Anwender"

(73) Patentinhaber: **TELEFUNKEN electronic GmbH,
Theresienstrasse 2, D-7100 Heilbronn (DE)**

(72) Erfinder: **Angerstein, Jörg, Dr. Dipl.- Phys.,
Talheimer Strasse 20/1, D-7101 Flein (DE)**
Erfinder: **Wagner, Elmar- Ernst, Dr. Dipl.- Phys.,
Goerdelerstrasse 12, D-7100 Heilbronn (DE)**
Erfinder: **Dermitzakis, Stefanos, Dipl.- Ing.,
Ludwigstrasse 40, D-7100 Heilbronn (DE)**

(74) Vertreter: **Maute, Hans- Jürgen, Dipl.- Ing.,
TELEFUNKEN electronic GmbH Theresienstrasse
2, D-7100 Heilbronn (DE)**

## Beschreibung

Moderne Halbleiter-Laser sind als Strahlungs-Quellen im CW-Betrieb bis zu hohen Modulations-Frequenzen (einige GHz) geeignet.

CW-Halbleiter-Laser werden so betrieben, daß in der Strom-Strahlungsleistungs-Kennlinie des Lasers, vorzugsweise oberhalb des Schwellenstromes $I_{th}$ durch einen Vorstrom $I_F$ ein bestimmter DC-Arbeitspunkt eingestellt wird. Darauf wird dann auf Bedarf ein digitales oder HF-Signal moduliert, oder der Laser wird einfach als DC-Strahlungsquelle verwendet. In jedem Fall ist es aus verschiedenen Gründen (Alterung, Temperaturabhängigkeit usw.) nötig, die optische Leistung des Lasers konstant zu halten bzw. zu stabilisieren.

Für die Stabilisierung wird vorwiegend eine mit der Laser-Strahlung optisch gekoppelte Photodiode verwendet, die meist mit dem Laser-Chip auf dem gleichen Träger aufgebaut ist. Der Photostrom der Photodiode steuert dann verstärkt über eine Regelschaltung den Strom $I_F$ des Lasers so, daß die Strahlungsleistung konstant bleibt.

Der Erfindung liegt die Aufgabe zugrunde, eine Schaltungsanordnung zur Ansteuerung von Halbleiter-Lasern mit Regelung der gesendeten optischen Leistung unter Verwendung einer mit der Laser-Strahlung optisch gekoppelten Photodiode dahingehend zu verbessern, daß der Schaltungsaufwand sehr gering, die Bandbreite groß und der Arbeitspunkt des Lasers einfach einstellbar sind, und daß die Schaltungsanordnung des weiteren grundsätzlich nur eine Versorgungsspannung erforderlich macht sowie eine einfache Ankopplung eines digitalen oder HF-Signals für die Modulation der Laser-Strahlung ermöglicht.

Diese Aufgabe ist erfindungsgemäß dadurch gelöst, daß die Photodiode als Signalquelle auf einen aus (wenigstens) zwei Transistoren gebildeten Transimpedanzverstärker arbeitet, dessen Ausgangsstrom zugleich der Steuerstrom des Halbleiter-Lasers ist.

Die Erfindung wird im nachstehenden anhand einiger Schaltungsbeispiele erläutert.

Es zeigen:

Fig. 1 eine Laser-Ansteuerung in der erfindungsgemäßen Grundform,

Fig. 2 eine hinsichtlich der Modulation der Laser-Strahlung durch Verwendung eines zusätzlichen Transistors modifizierte Schaltungsanordnung,

Fig. 3 eine Schaltungsanordnung mit Einstellung des Arbeitspunktes des Lasers mit Hilfe einer Referenzspannung und mit einem zusätzlichen Transistor zur Modulation der Laser-Strahlung mit einem digitalen oder HF-Signal,

Fig. 4 eine Variante der Grundschaltung gemäß Fig. 1 mit einem zusätzlichen Transistor, der mit dem ersten Transistor des Transimpedanzverstärkers eine Stromspiegelschaltung bildet,

Fig. 5 eine modifizierte Schaltungsanordnung, bei der die in der Schaltung nach Fig. 1 vorgesehen, den Laserstrom bestimmenden Widerstände durch eine aus zwei Transistoren gebildete Stromspiegelschaltung ersetzt sind.

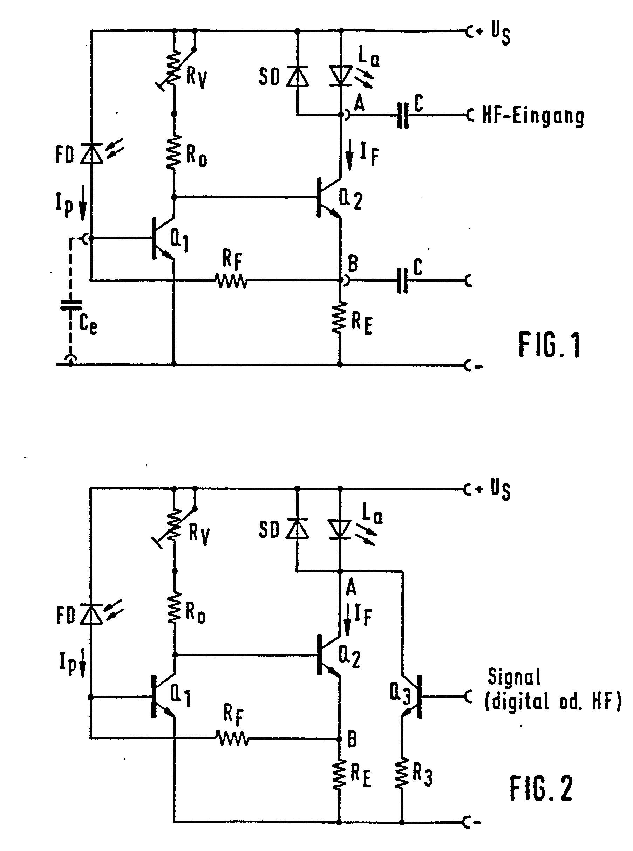

In Fig.1 ist die Laser-Ansteuerschaltung in der Grundform dargestellt. Sie besteht aus den beiden Transistoren $Q_1$, $Q_2$, der Photodiode FD und vier Widerstanden $R_E$, $R_F$, $R_0$ und $R_V$ wobei $R_V$ als Einstellwiderstand ausgebildet ist.

Die Diode SD ist als Schutzdiode antiparallel zum Laser geschaltet und hat keine weitere Funktion, außer den Laser vor negativen Spannungen zu schützen. Sie sollte deshalb eine schnelle Schaltdiode sein.

Die Transistoren $Q_1$ und $Q_2$ bilden einen Transimpedanzverstärker mit der Photodiode FD als Signalquelle. Der Ausgangsstrom des Verstärkers, d.h. der Kollektorstrom von $Q_2$, ist gleichzeitig der Steuerstrom $I_F$ des Halbleiter-Lasers $L_a$.

Der Laserstrom $I_F$ steht somit über der Stromverstärkung $V_i$ des Verstärkers mit dem Photostrom $I_p$ direkt in Beziehung.

Es gilt angenähert: $V_i \approx \frac{R_F}{R_i} = \frac{I_F}{I_p}$

oder $I_F = -I_p.V_i$.

Der Photostrom $I_p$ ist proportional zu der optischen Leistung P, die vom Laser ausgestrahlt wird:

$I_p$ - S.P.

Dabei bedeutet S die Empfindlichkeit der Photodiode.

Somit ergibt sich:

$I_F = -S\, V_i\, P.$

Das heißt, für jede Änderung $\Delta P$ der Leistung tritt die Stromänderung $\Delta I_F = -S.V_i.\Delta P$ auf, die auf der Laser-Kennlinie den Arbeitspunkt so verschiebt, daß die Änderung der Leistung verkleinert wird und verschwindet.

Da der Transimpedanzverstärker, der die Gegenkopplung durchführt, ein ausgesprochener Breitbandverstärker mit hoher Grenzfrequenz ist, bleibt auch die optische Gegenkopplung und Regelung bis zu sehr hohen Frequenzen wirksam. Genauer gesagt, bis zu der Grenzfrequenz $f_g$ des Verstärkers mit der Photodiode als Quelle.

Für Frequenzen größer als die Grenzfrequenz $f_g$ der Regelstrecke wirkt die Regelung so, dan die optische Leistung auf einen bestimmten Mittelwert stabilisiert wird. Die Grenzfrequenz $f_g$ des Transimpedanzverstärkers ist bei der Verwendung von HF-Transistoren für $Q_1$, $Q_2$ angenähert umgekehrt proportional zu dem Produkt $R_F.C_F$,

$$f_g \sim \frac{1}{2\pi.R_F.C_p}\quad,$$

wobei $C_p$ die Kapazität der Photodiode und $R_F$ der Gegenkopplungs-Widerstand des Verstärkers sind.

Mit kapazitätsarmen schnellen Photodioden

erreicht $f_g$ sehr hohe Werte. Andererseits ist sehr oft erwünscht, auf einen Mittelwert der optischen Leistung zu stabilisieren. In diesem Fall wird durch Zuschalten von externen Kapazitäten $C_e$ am Eingang vom Verstärker die Grenzfrequenz auf dem gewünschten Wert herabgesetzt.

Die Modulation der Laser-Strahlung mit einem Signal kann am Punkt A oder Punkt B über eine Kapazität C erfolgen.

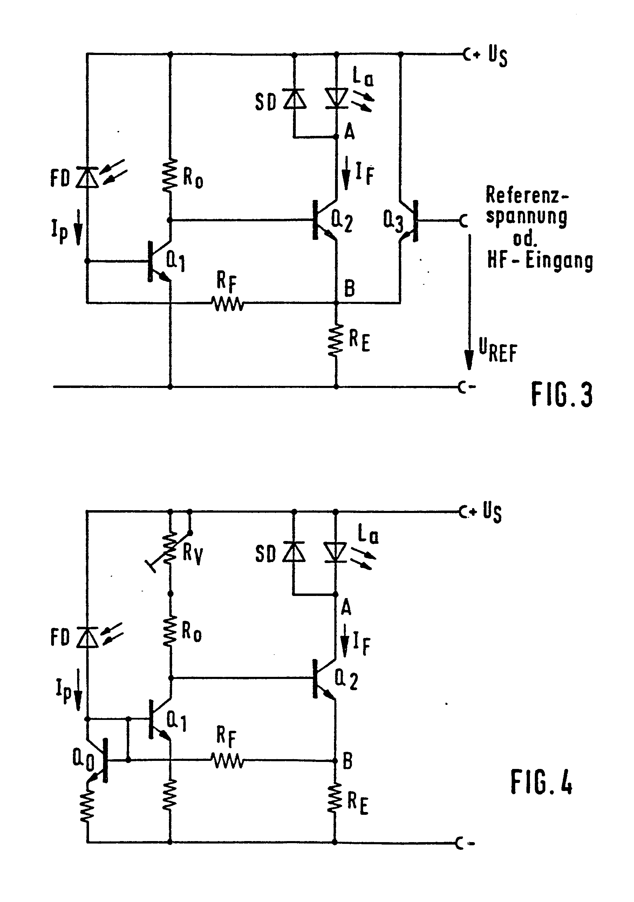

Eine andere Möglichkeit, die Laser-Strahlung mit einem digitalen oder Hf-Signal zu modulieren, wird in Fig. 2 und Fig. 3 gezeigt. Es wird hier ein zusätzlicher Transistor $Q_3$ verwendet, der mit seinem Emitter am Punkt B, Fig. 3, oder mit seinem Kollektor am Punkt A, Fig. 2, angeschlossen ist, wobei in diesem Fall der Emitter über einen Widerstand $R_3$ am Minuspol der Speisespannungsquelle liegt. Über die Basis des Transistore $Q_3$ kann dann in beiden Fällen der Laser $L_a$ mit dem Nutzsignal moduliert werden.

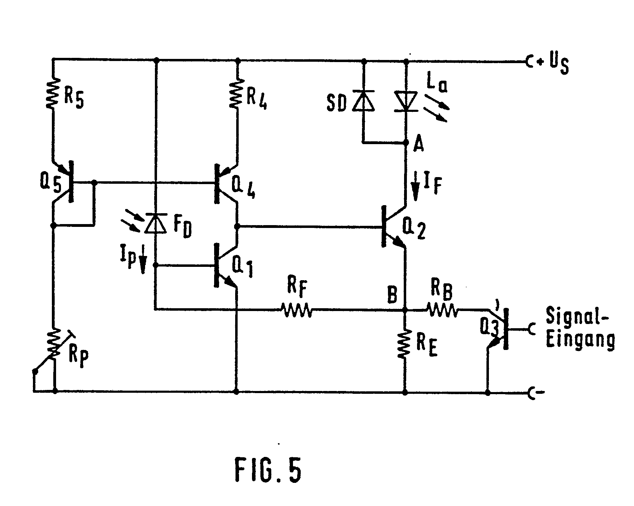

Zur Modulation der Laser-Strahlung mit einem externen Signal am Punkt B eignet sich auch die in Fig. 5 dargestellte Schaltungsvariante. Hier wird ebenfalls ein zusätzlicher Transistor $Q_3'$ verwendet, der mit dem Widerstand $R_B$ parallel zum Widerstand $R_E$ liegt.

Der Transistor $Q_3'$ kann auch der Ausgang eines TTL-Gatters mit Open-Collector-Ausgängen sein.

Die Bescheltung von $Q_3$ in Fig. 3 entspricht dem Ausgang eines ECL-Gatters. am Punkt B kann demnach der Laser direkt auch mit einem Gatter dieser schnellen Logik moduliert werden.

Der Arbeitspunkt und der Arbeitsbereich des Lasers in der Strom-Leistungs-Kennlinie wird im Falle der Figuren 1, 2 und 4 grob mit dem Widerstand $R_E$ und fein mit dem Widerstand $R_V$ eingestellt. Bei vorgegebenen Widerständen $R_F$ und $R_E$ bestimmt der Widerstand $R_0$ den maximalen Strom $I_{Fmax}$ und die Summe $R_0 + R_{Vmax}$ den minimalen Strom $I_{Fmin}$. durch den Laser $L_a$.

Zwei weitere Möglichkeiten, den Arbeitspunks des Lasers einzustellen, zeigen die Figuren 3 und 5. Bei der Schaltungsanordnung gemäß Fig. 3 wird der Arbeitspunkt mit Hilfe einer Referenzspannung $U_{REF}$ an der Basis des Transistors $Q_3$ festgelegt. In diesem Fall entfällt der Widerstand $R_V$, so daß zwischen der Basis des ersten Transistors $Q_1$ und dem Pluspol der Speisespannungsquelle lediglich noch der Widerstand $R_0$ liegt.

Bei der Schaltungsanordnung nach Fig. 5 sind die Widerstände $R_V$, $R_0$ durch eine Stromspiegelschaltung $Q_4$, $Q_5$ ersetzt. Die Feineinstellung des Arbeitspunktes geschieht hier mit dem variablen Widerstand $R_p$. Der Einstellwiderstand $R_V$ in Figur 1 ist hier zwischen den Minuspol und die miteinander verbundenen Kollektor-Basisanschlüsse des Transistors $Q_5$ verlegt.

Der Vorteil der Schaltungsanordnung nach Fig. 5 gegenüber derjenigen gemäß Fig. 1 liegt darin, daß im Fall der Fig. 5 am Kollektor von $Q_1$ jetzt der Kollektor von $Q_4$ als Stromquelle angeschlossen ist. Diese Stromquelle (Kollektor von $Q_4$) entspricht, fast unabhängig vom Strom einem großen Lastwiderstand für den Transistor $Q_1$, so daß die innere Verstärkung des aus den Transistoren $Q_1$ und $Q_2$ bestehenden Transimpedanzverstärkers in einem weiten Streubereich groß und stabil bleibt.

Damit werden auch die Eigenschaften das Transimpedanzverstärkers wenig abhängig vom eingestellten Arbeitpunkt und Strom. Die Emitter der PNP-Transistoren $Q_4$ und $Q_5$ sind jeweils über einen Widerstand $R_4$ bzw. $R_5$ mit der am Pluspol der Spannungsquelle $U_S$ liegenden Kathode der Photodiode FD leitend verbunden.

In Fig. 4 ist eine weitere Variante der Grundschaltung von Fig. 1 dargestellt. Es wird hier ein zusätzlicher Transistor $Q_0$ verwendet, der mit dem Transistor $Q_1$ Stromspiegelschaltung bildet. $Q_1$ und $Q_2$ sind immer noch als Transimpedanzverstärker beschaltet.

Diese Schaltung hat als Vorteil eine sehr gute Temperaturstabilität, falls die Transistoren $Q_1$ und $Q_0$ miteinander thermisch gekoppelt sind.

Die Grenzfrequenz der Regelschaltung nach der Erfindung erreicht bei Verwendung geeigneter HF- oder UHF-Transistoren Werte von einigen 100MHZ und ist primär nur durch die Grenzfrequenz der Photodiode FD begrenzt. Im Bedarfsfall kann die Schaltung auch an zwei Versorgungsspannungen angeschlossen werden.

## Patentansprüche

1. Schaltungsanordnung zur Ansteuerung von Halbleiter-Lasern ($L_a$) mit Regelung der gesendeten optischen Leistung unter Verwendung einer mit der Laser-Strahlung optisch gekoppelten Photodiode (FD), deren verstärkter Photostrom den Strom des Lasers so steuert, daß dessen Strahlungsleistung konstant bleibt, dadurch gekennzeichnet, daß die Photodiode (FD) als Signalquelle auf einen aus wenigstens zwei Transistoren ($Q_1$, $Q_2$) gebildeten Transimpedanzverstärker arbeitet, dessen Ausgangsstrom zugleich der Steuerstrom des Halbleiterlasers ($L_a$) ist.

2. Schaltungsanordnung nach Anspruch 1, dadurch gekennzeichnet, daß zwischen dem Kollektor des ersten, basisseitig an die Anode der Photodiode (FD) angeschlossenen Transistors ($Q_1$) und der Kathode der Photodiode ein Feineinstellwiderstand ($R_V$) für den Arbeitspunkt des Lasers ($L_a$) angeordnet ist und zwischen den Emitter des im Laserkreis liegenden zweiten Transistors ($Q_2$) und die Basis des ersten Transistors ($Q_1$) ein Gegenkopplungswiderstand ($R_F$) geschaltet ist.

3. Schaltungsanordnung nach Anspruch 2, dadurch gekennzeichnet, daß mit dem Feineinstellwiderstand ($R_V$) ein Widerstand ($R_0$) in Reihe geschaltet ist, wobei der Widerstand ($R_0$) den maximalen Strom und die Summe der Widerstände ($R_0 + R_{Vmax}$) den minimalen Strom durch den Laser bestimmen.

4. Schaltungsanordnung nach den Ansprüchen 1 und 2, dadurch gekennzeichnet, daß dem im Kollektorkreis des zweiten Transistors ($Q_2$) liegenden Laser ($L_a$) eine Schutzdiode (SD) antiparallel geschaltet ist.

5. Schaltungsanordnung nach den Ansprüchen 1 bis 4, gekennzeichnet durch die Verwendung einer kapazitätsarmen schnellen Photodiode.

6. Schaltungsanordnung nach den Ansprüchen 1 bis 5, dadurch gekennzeichnet, daß an den Eingang des Transimpedanzverstärkers externe Kapazitäten ($C_e$) zuschaltbar sind.

7. Schaltungsanordnung nach einem oder mehreren der vorhergehenden Ansprüche, dadurch gekennzeichnet, daß die Laser-Strahlung mit einem digitalen oder HF-Signal über eine an den Kellektor oder an den Emitter des laserseitigen Transistors ($Q_2$) angeschlossene Kapazität (C) modulierbar ist.

8. Schaltungsanordnung nach einem oder mehreren der Ansprüche 1 bis 6, dadurch gekennzeichnet, daß die Modulation der Laser-Strahlung über einen zusätzlichen Transistor ($Q_3$) erfolgt, der der Reihenschaltung aus Laser ($L_a$) und im Laserkreis liegenden Transistor ($Q_2$) parallel geschaltet und emitterseitig an den Emitter des im Laserkreis liegenden Transistors ($Q_2$) angeschlossen ist und über dessen Basis der Laser ($L_a$) mit dem Nutzsignal moduliert wird.

9. Schaltungsanordnung nach Anspruch 8, dadurch gekennzeichnet, daß der Laser unmittelbar mit einem ECL-Gatter moduliert wird.

10. Schaltungsanordnung nach Anspruch 8, dadurch gekennzeichnet, daß zur Einstellung des Arbeitspunkts des Lasers ($L_a$) anstelle eines einstellbaren Widerstands eine an die Basis des zusätzlichen Transistors ($Q_3$) gelegte Referanzspannung dient.

11. Schaltungsanordnung nach einem oder mehreren der Ansprüche 1 bis 6, dadurch gekennzeichnet, daß zur Modulation der Laser-Strahlung ein zusätzlicher Transistor ($Q_3$) vorgesehen ist, der zu der aus dem im Laserkreis liegenden Transistor ($Q_2$) des Transimpedanzverstärkers und einam mit diesem in Reihe liegenden Widerstand ($R_E$) gebildeten Reihenschaltung parallel geschaltet und kollektorseitig an den Kollektor des laserseitigen Transistors ($Q_2$) angeschlossen ist, und über dessen Basis der Laser ($L_a$) mit dem Nutzsignal moduliert wird, wobei der Emitter des zusätzlichen Transistors ($Q_3$) über einen Widerstand ($R_3$) am Minuspol der Speisespannung liegt.

12. Schaltungsanordnung nach einem oder meherern der vorhergehenden Ansprüche, dadurch gekennzeichnet, daß dem ersten Transistor ($Q_1$) des Transimpedanzverstärkers ein Transistor ($Q_0$) im Stromspiegelschaltung zugeordnet ist.

13. Schaltungsanordnung nach den Ansprüchen 1 und 4 bis 6, dadurch gekennzeichnet, daß mit dem Kollektor des ersten Transistors ($Q_1$) der Kollektor eines PNP

Transistors ($Q_4$) elektrisch leitend verbunden ist, der emitterseitig über einen Widerstand ($R_4$) an die Kathode der Photodiode (FD) angeschlossen ist und mit einem weiteren PNP-Transistor ($Q_5$) eine Stromspiegelschaltung bildet.

14. Schaltungsanordnung nach Anspruch 13, dadurch gekennzeichnet, daß zwischen den Minuspol der Spannungsquelle und den miteinander verbundenen Kollektor-Basisanschlüssen des Transistors ($Q_5$) ein Feineinstellwiderstand ($R_p$) geschaltet ist.

15. Schaltungsanordnung nach den Ansprüchen 13 und 14, dadurch gekennzeichnat, daß zur Modulation der Laser-Strahlung ein Transistor ($Q_3'$) vorgesehen ist, der emitterseitig am Minuspol der Spannungsquelle liegt und kollektorseitig an einen Widerstand ($R_B$) angeschlossen ist, und daß die aus dem Transistor ($Q_3'$) und dem Widerstand ($R_B$) gebildete Reihenschaltung parallel zu einem Grobeinstellwiderstand ($R_E$) liegt.

## Claims

1. Circuit arrangement for driving a semiconductor laser ($L_a$) wherein the transmitted optical power is controlled using a photodiode (FD) which is optically coupled with the laser radiation and whose amplified photocurrent controls the current of the laser such that its radiation power remains constant, characterized in that the photodiode (FD) operates as signal source onto a transimpedance amplifier which is comprised of at least two transistors ($Q_1$, $Q_2$) and whose output current is simultaneously the control current of the semiconductor laser ($L_a$).

2. Circuit arrangement as defined in Claim 1, characterized in that a fine adjustment resistor ($R_V$) for the operation point of the laser ($L_a$) is arranged between the collector of the first transistor ($Q_1$), whose base is connected to the anode of the photodiode (FD), and the cathode of the photodiode, and a feedback resistor ($R_F$) is connected between the emitter of the second transistor ($Q_2$) located in the laser circuit and the base of the first transistor ($Q_1$).

3. Circuit arrangement as defined in Claim 2, characterized in that a resistor ($R_o$) is connected in series with the fine adjustment resistor ($R_V$), with the resistance ($R_o$) determining the maximum current and the sum of the resistances ($R_o + R_{Vmax}$) the minimum current through the laser.

4. Circuit arrangement as defined in Claims 1 and 2, characterized in that a damping diode (SD) is connected in antiparallel with the laser ($L_a$) located in the collector circuit of the second transistor ($Q_2$).

5. Circuit arrangement as defined in Claims 1 to 4, characterized by use of a low-capacitance rapid photodiode.

6. Circuit arrangement as defined in Claims 1 to 5, characterized in that external capacitances ($C_e$)

are connectable to the input of the transimpedance amplifier.

7. Circuit arrangement as defined in one or several of the preceding Claims, characterized in that the laser radiation can be modulated with a digital or HF signal via a capacitance (C) connected to the collector or to the emitter of the transistor ($Q_2$) located in the laser circuit.

8. Circuit arrangement as defined in one or several of Claims 1 to 6, characterized in that the laser radiation is modulated via an additional transistor ($Q_3$) which is connected in parallel with the series connection comprised of the laser ($L_a$) and the transistor ($Q_2$) located in the laser circuit, and whose emitter is connected to the emitter of the transistor ($Q_2$) located in the laser circuit, and via whose base the laser ($L_a$) is modulated with the useful signal.

9. Circuit arrangement as defined in Claim 8, characterized in that the laser is directly modulated with an ECL gate.

10. Circuit arrangement as defined in Claim 8, characterized in that instead of an adjustable resistance, a reference voltage applied to the base of the additional transistor ($Q_3$) serves to set the operation point of the laser ($L_a$).

11. Circuit arrangement as defined in one or several of Claims 1 to 6, characterized in that there is provided for modulation of the laser radiation an additional transistor ($Q_3$) which is connected in parallel with the series connection comprised of the transistor ($Q_2$) of the transimpedance amplifier located in the laser circuit and a resistor ($R_E$) arranged im series therewith, whose collector is connected to the collector of the transistor ($Q_2$) located in the laser circuit, and via whose base the laser ($L_a$) is modulated with the useful signale with the emitter of the additional transistor ($Q_3$) being connected via a resistor ($R_3$) to the negative pole of the supply voltage.

12. Circuit arrangement as defined in one or several of the preceding Claims, characterized in that a transistor ($Q_o$) of a current mirror circuit is associated with the first transistor ($Q_1$) of the transimpedance amplifier.

13. Circuit arrangement as defined in Claims 1 and 4 to 6, characterized in that the collector of a PNP transistor ($Q_4$), whose emitter is connected via a resistor ($R_4$ to the cathode of the photodiode (FD), and which forms a current mirror circuit with a further PNP transistor ($Q_5$, is electrically conductively connected to the collector of the first transistor ($Q_1$).

14. Circuit arrangement as defined in Claim 13, characterized in that a fine adjustment resistor ($R_p$) is connected between the negative pole of the voltage source and the collector-base connections of the transistor ($Q_5$) which are connected with one another.

15. Circuit arrangement as defined in Claims 13 and 14, characterized in that there is provided for modulation of the laser radiation a transistor ($Q_3'$) whose emitter is connected to the negative pole of the voltage source and whose collector is connected to a resistor ($R_B$), and in that the series connection comprised of the transistor ($Q_3'$) and the resistor ($R_B$) is arranged in parallel with a coarse adjustment resistor ($R_E$).

**Revendications**

1. Dispositif d'excitation de lasers à semiconducteurs ($L_a$) avec régulation de la puissance optique émise à l'aide d'une photodiode (FD) couplée optiquement au rayonnement laser et dont le courant photoélectrique amplifié commande le courant du laser de façon que sa puissance rayonnée demeure constante, ledit circuit étant caractérisé en ce que la photodiode (FD) constituant la source de signal fonctionne sur un amplificateur de transimpédance formé par au moins deux transistors ($Q_1$, $Q_2$) et dont le courant de sortie est simultanément le courant de command, du laser à semiconducteurs ($L_a$).

2. Circuit selon revendication 1, caractérisé en ce qu'une résistance ($R_V$) de réglage fin du point de fonctionnement du laser ($L_a$) est disposée entre le collécteur du premier transistor ($Q_1$), dont la base est relié à l'anode de la photodiode (FD), et la cathode de la photodiode, et une résistance de contre-réaction ($R_F$) est insérée entre l'émetteur du second transistor ($Q_2$), situé dans le circuit laser, et la base du premier transistor ($Q_1$).

3. Circuit selon revendication 2, caractérisé en ce que la résistance de réglage fin ($R_V$) est en siérie avec une résistance ($R_o$) qui détermine le courant maximal alors que la somme des résistances ($R_o + R_{Vmax}$) détermine le courant minimal dans le laser.

4. Circuit selon revendications 1 et 2, caractérisé par le couplage antiparallèle d'une diode protectrice (SD) avec le laser ($L_a$) inséré dans le circuit collecteur du second transistor ($U_2$).

5. Circuit selon revendications 1 à 4, caractérisé par l'utilisation d'une photodiode rapide à faible capacité.

6. Circuit selon revendications 1 à 5, caractérisé en ce que des capacités externes ($C_e$) sont connectables à l'entrée de l'amplificateur de transimpédance.

7. Circuit selon une quelconque des revendications 1 à 6, caractérisé en ce que le rayonnement laser est modulable par un signal numérique ou RF à l'aide d'une capacité (C) reliée ou collecteur ou à l'émetteur du transistor ($Q_2$) situé du côté laser.

8. Circuit selon une quelconque des revendications 1 à 6, caractérisé en ce que la modulation du rayonnement laser s'effectue par un transistor supplémentaire ($Q_3$) en parallèle avec le branchement en série du laser ($L_a$) et du transistor ($Q_2$) inséré dans le circuit du laser, dont l'émetteur est relié à l'émetteur du transistor ($Q_2$) inséré dans le circuit du laser et dont la base

module le laser ($L_a$) par le signal utile.

9. Circuit selon revendication 8, caractérisé en ce que le laser est modulé directement par un opérateur ECL.

10. Circuit selon revendication 8, caractérisé en ce qu'une résistance variable est remplacée par une tension de référence appliquée sur la base du transistor supplémentaire ($Q_3$) pour le réglage du point de fonctionnement du laser ($L_a$).

11. Circuit selon une quelconque des revendications 1 à 6, caractérisé en ce qu'un transistor supplémentaire ($Q_3$) est prévu pour la modulation du rayonnement laser, est branché en parallèle avec le montage en série du transistor ($Q_2$) de l'amplificateur de transimpédance inséré dans le circuit du laser et d'une résistance ($R_E$), dont le collecteur est relié au collecteur du transistor ($Q_2$) inséré dans le circuit du laser et dont la base module le laser ($L_a$) par le signal utile, l'émetteur du transistor supplémentaire ($Q_3$) étant relié par une résistance ($R_3$) à la borne négative de la tension d'alimentation.

12. Circuit selon une quelconque des revendications 1 à 11, caractérisé en ce qu'un transistor ($Q_o$) est affecté au premier transistor ($Q_1$) de l'amplificateur de transimpédance pour former un miroir de courant.

13. Circuit selon une quelconque des revendications 1 et 4 à 6, caractérisé en ce que le collecteur du premier transistor ($Q_1$) est relié au collecteur d'un transistor PNP ($Q_4$), dont l'émetteur est relié par une résistance ($R_4$) à la cathode de la photodiode (FD) et qui, avec un second transistor PNP ($Q_5$), forme un miroir de courant.

14. Circuit selon revendication 13, caractérisé en ce qu'une résistance de réglage fin ($R_p$) est insérée entre la borne négative de la source de tension et les bornes de collecteur et de base reliées entre elles du transistor ($Q_5$).

15. Circuit selon revendications 13 et 14, caractérisé en ce qu'un transistor ($Q_3'$) est prévu pour la modulation du rayonnement laser, dont l'émetteur est relié à la borne négative de la source de tension et dont le collecteur est relié à une résistance ($R_B$); et le montage en série du transistor ($Q_3'$) et de la résistance ($R_B$) est en parallèle avec une résistance de préréglage ($R_E$).

FIG.1

FIG.2

FIG.3

FIG.4

FIG.5